# EUROPEAN PATENT SPECIFICATION

(11) **EP 1 314 990 B1**
(45) Date of publication and mention of the grant of the patent: **09.08.2006**
(21) Application number: 01000658.3
(22) Date of filing: 23.11.2001
(51) Int. Cl.: G01R 31/36

(54) **Method for evaluating a battery and the device for the same**
Verfahren zur Auswertung einer Batterie und dieses Verfahren verwendendes Gerät
Méthode pour évaluer une batterie et un tel dispositif

(43) Date of publication of application: 28.05.2003
(73) Proprietor: DHC Specialty Corp., Taipei (TW)
(72) Inventor: CHO, Henry, , TAIPEI (TW)
(74) Representative: Hooiveld, Arjen Jan Winfried

(56) References cited:
- US-A- 5 945 805
- PATENT ABSTRACTS OF JAPAN vol. 018, no. 175 (P-1716), 24 March 1994 (1994-03-24) & JP 05 341022 A (MITSUBISHI MOTORS CORP;OTHERS: 01), 24 December 1993 (1993-12-24)
- PATENT ABSTRACTS OF JAPAN vol. 007, no. 278 (P-242), 10 December 1983 (1983-12-10) & JP 58 156871 A (NISSAN JIDOSHA KK), 17 September 1983 (1983-09-17)

## Description

### 1. Field of the Invention

The invention relates to a method for evaluating a battery and a battery tester.

### 2. Description of Related Art

Current methods for determining the condition of a battery (e.g., a lead acid vehicle battery, such as an automotive battery) can deliver a high current typically require the use of heavy, bulky test equipment. The methods can also require that the battery have enough charge to perform the test. Other methods may use a smaller current, but these methods may depend heavily on the battery's state-of-charge, thereby making it difficult to test a battery that is deeply discharged. Additionally, the current methods for determining a battery's condition may take longer than is desired to perform a test. For example, US patent document 5,945,805 and Japanese patent publications JP 05-341022 and JP 58-56871 disclose such related technology.

In one aspect, evaluating the condition of a battery includes applying a load to the battery for a first time period of three milliseconds to ten seconds, measuring a first voltage at the end of the first time period, removing the load, measuring a second voltage at the end of a first recovery time period after removing the load, measuring a third voltage at the end of a second recovery time period after removing the load, and analyzing the condition of the battery. The second recovery time period can be longer than the first recovery time period.

Anaylizing the condition of the battery can include calculating a dynamic internal resistance for the battery at the end of the second recovery time period, and determining the condition of the battery based on the dynamic internal resistance of the battery. In certain embodiments, analyzing the condition of the battery can include displaying a capacity of the battery, a state of charge of the battery, and an indication of pass or fail. The method can include inputting a capacity of the battery and selecting the load to apply to the battery based on the capacity. Inputting the capacity can include selecting between an input based on one of cold cranking amps, cranking amps, amp hours, or other rating standard.

In another aspect, an electronic battery tester device includes a housing containing a load, a switch, cables exiting the housing for making electrical contact with terminals on the battery and contacting the switch, and an analyzing component that is structured and arranged to analyze the condition of the battery at the end of a first recovery time period and a second recovery time period. The switch applies the load to the battery for a first time period of between three milliseconds and ten seconds and removes the load from the battery. The analyzing component can include a calculating component that is structured and arranged to calculate the dynamic internal resistance for the battery and a determining component that is structured and arranged to determine the condition of the battery based on the dynamic internal resistance of the battery.

Implementations may include one or more of the following features. For example, the second time period may include a first recovery time period and a second recovery time period, where the second recovery time is longer than the first recovery time period. The first recovery period can be eight milliseconds to fifteen milliseconds, or ten milliseconds, The second recovery period can be forty milliseconds to eight hundred milliseconds, or sixty milliseconds. The condition of the battery may be analyzed by calculating a dynamic internal resistance for the battery and determining the condition of the battery based on the dynamic internal resistance of the battery. The load may be between eighty amps and one hundred amps and may be based on inputting a rating system and a capacity for the battery being tested.

The method and tester carry out a single load, dynamic internal resistance measurement. The method and tester can obtain battery condition results within one second, and with high precision. The tester and method can reduce or eliminate the amount of heat generated during testing and is not affected by magnetic fields generated by other devices located nearby.

These general and specific aspects may be implemented using a device, a method, or a computer program, or any combination of devices, methods, and computer programs. For instance, one implementation may include a hand-held electronic battery tester device. The device may be used for evaluating a battery (e.g., lead acid automotive battery).

Other features and advantages will be apparent from the description and drawings, and from the claims.

### In the drawings

Fig. 1 is a picture of an electronic battery tester;
Fig. 2 is a block diagram of an electronic battery tester;
Fig. 3 is flow chart for selecting the rating of a battery;
Fig.4 is a flow chart for selecting the capacity of a battery;
Fig 5 is a flow chart for the process of evaluating the condition of a battery; and
Fig. 6 is graph of battery voltage versus time.

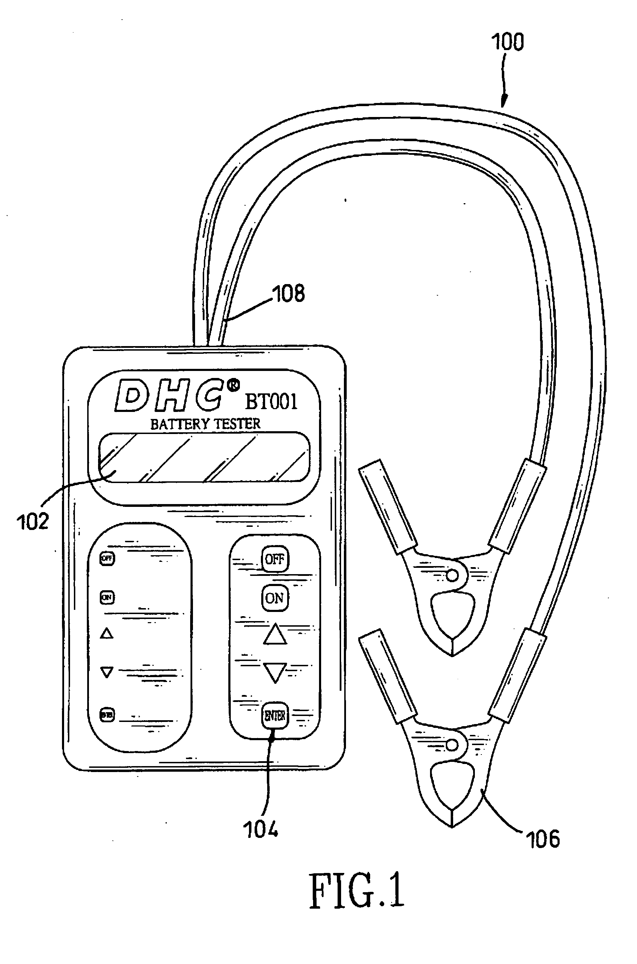

Referring to Fig 1, an external view of an electronic battery tester device (100) is shown. In one implementation, the device (100) may be sized to fit in the palm of a user's hand. The device (100) typically includes a display module (102) (e.g., a liquid crystal display module (LCM)) for providing alphanumeric information, such as, information regarding the condition of the battery being tested, information regarding the selection of test inputs, and information regarding the status of the device (100). For example, the device (100) may display the battery capacity, the state of charge, and a pass or fail readout. The display module (102) may include one or more lines for displaying the alphanumeric information. The display lines may be fixed or may scroll the information.

The device (100) also typically includes a keypad (104) for operation the device (100). The buttons on the keypad (104) may have various definitions and may perform various different functions. For instance, buttons on the keypad (104) may include an "Off button for turning powering down the device (100), an "On" button for stating the device (100), and an "Enter" button for confirming selections and beginning the test procedure. Other buttons may include buttons to select various functions and to make changes to selections (e.g., an "up arrow" button and a "down arrow" button). The device (100) also may automatically power down and shut off if it has been idle for a predetermined period of time.

The device (100) also typically includes two clamps (106) for connected to the device (100) via cables (108). The clamps (106) are used to connect the device (100) to the respective terminals of the battery being tested.

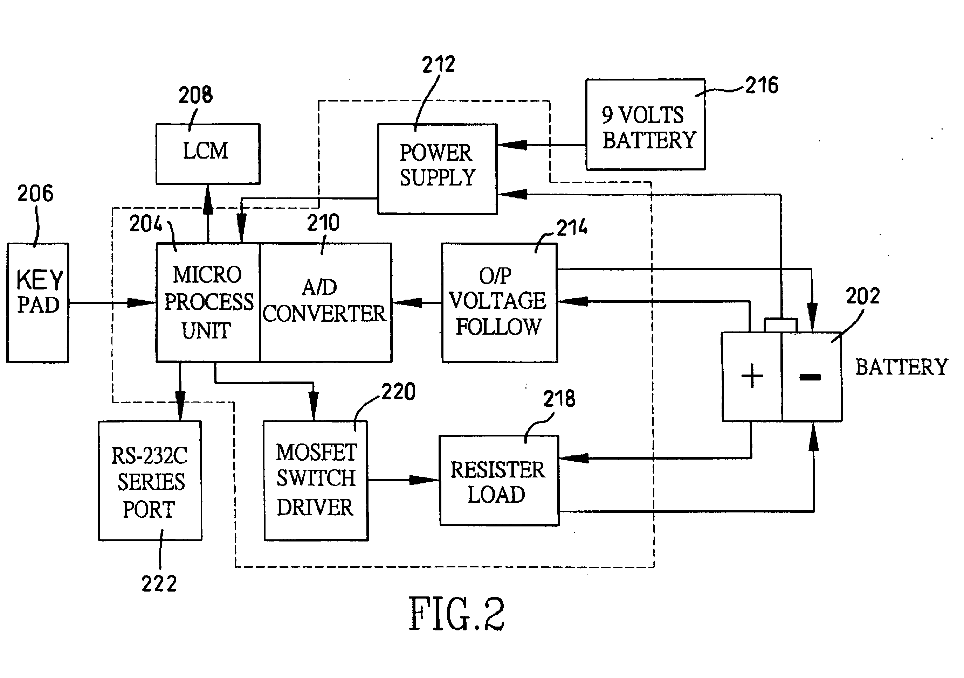

Referring to Fig. 2, a block diagram of the electronic battery tester device (200) is shown for evaluating the condition of a battery (202). The device (200) may test batteries of various voltages (e.g., a six volt battery and a twelve volt battery including a lead acid automotive battery). The device (200) typically includes a microprocessor (204), a keypad (206) corresponding to the keypad (104) of Fig. 1, a display (208) corresponding to the display (102) of Fig. 1, an analog-to-digital converter (210), a power supply (212), an operational amplifier (214), a battery (216) (e.g., a nine volt battery, or AA batteries) to power the tester, a resistor load (218), a switch driver (220) (e.g., a MOSFET switch driver), and a port (222). The microprocessor (204) is typically used in conjunction with the analog-to-digital converter (210) and the operational amplifier (214) to measure the voltage of the battery (202). The resistor load (218) may be selectable based on the battery's (202) stated rating and capacity, which may be included an as input parameter to the device (200). For instance, a 1 ohm resistor or a 0.1 ohm resistor may be selected as the resistor load (218) based on the inputted rating and capacity of the battery (202). The switch driver (220) is used to switch the resistor load (218) on and off during the evaluation of the battery's condition. The port (222) (e.g., RS-232C series port) may be used to connect and external device, such as a printer or a flash memory device that downloads software of programs, to the device (200).

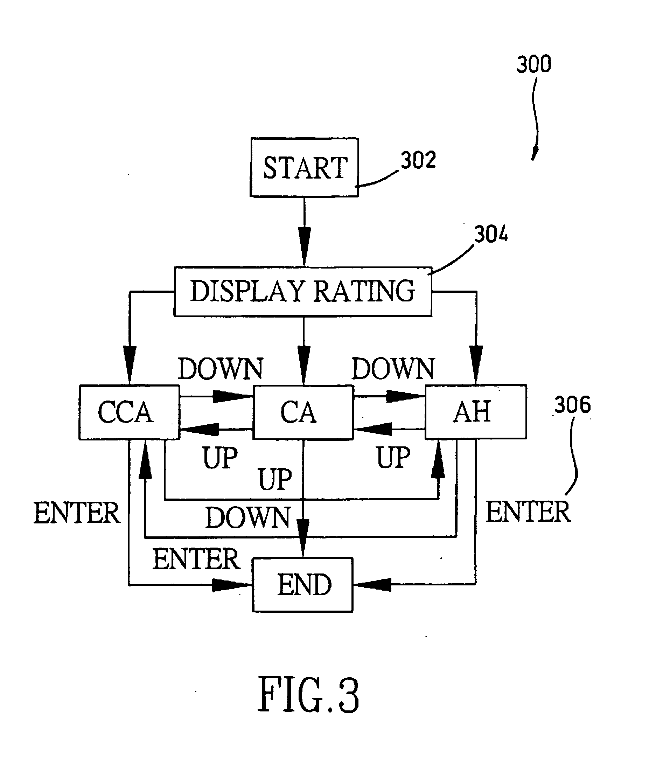

Referring to Fig.3 a process (300) for selecting the rating of the battery to be tested is shown. The electronic battery tester device typically allows one of several different rating systems to be selected. For instance, in one implementation, a user may select "cold cranking amps" (CCA), "cranking amps"(CA), or "amp-hours"(AH), Other rating systems also may be selected. The process (300) typically includes starting (302) the process, displaying a rating system for selection (304), and confirming a displayed rating system (306) by depressing the "enter" button on the keypad. The various rating systems may be displayed (304) by using the up and down arrows on the keypad.

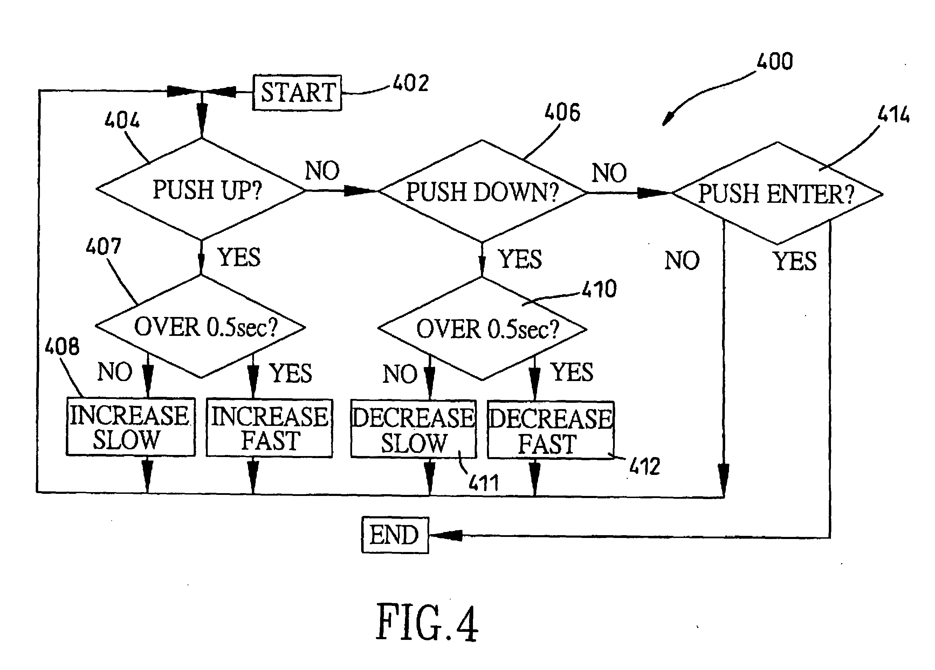

After a rating system has been selected, the stated capacity of the battery being tested is typically selected. Referring to Fig.4, process (400) is shown for selecting the capacity of the battery. The process (400) typically includes starting (402) the process, increasing (404) or decreasing (406) the displayed capacity by depressing the up or down arrows on the keypad, increasing slowly if the up arrow is depressed and held for less than 0.5 seconds (407, 408), increasing fast if the up arrow is depressed and held for more than 0.5 seconds (407, 409), decreasing slowly if the down arrow is depressed and held for less than 0.5 seconds (410,411), decreasing fast if the down arrow is depressed and held for more than 0.5 seconds (410, 412), and confirming a selection (414) by depressing the enter button on the keypad. In one implementation, the battery tester device may evaluate batteries with a range of between 40 to 2000 CCA, 50-2500 CA, 5-250 AH, and between 1 and 15 volts. The tester may test batteries that have been deeply discharged, such as batteries that have been discharged down to 1 volt.

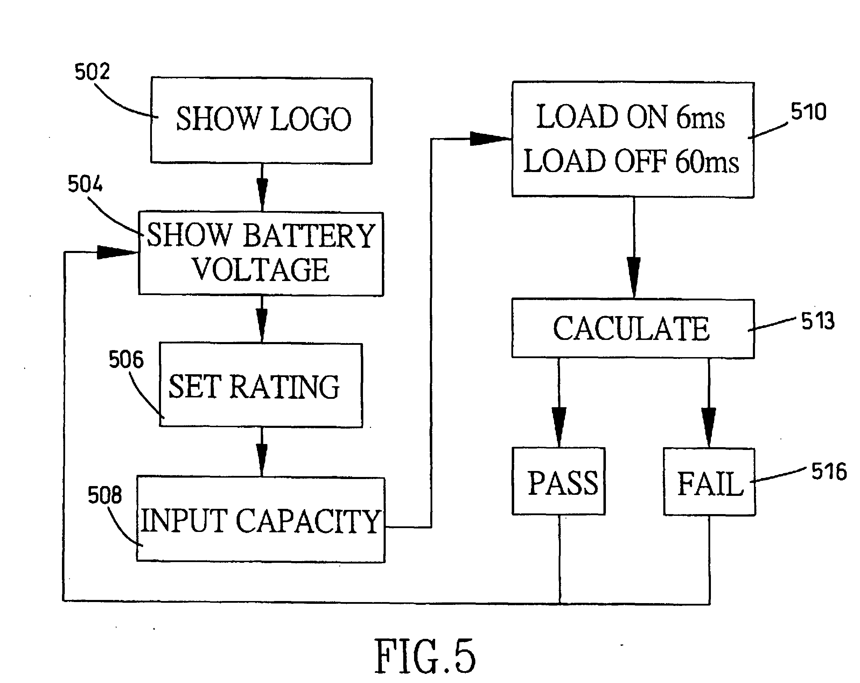

Referring to Fig. 5, a block diagram of the process (500) for evaluating the condition of a battery is shown. The process (500) typically includes displaying a first screen (502) that may include instructions or a logo, showing the battery voltage of the battery being tested (504), inputting the rating of the battery (506), inputting the capacity of the battery (508), applying and removing a load (510), calculating the condition of the battery (513), and displaying the evaluation results (516), which may include showing the battery voltage (504).

More particularly, the rating system of the battery is selected (506) as described above with respect of Fig. 3. The stated capacity of the battery is selected (508) as described above with respect to Fig. 4. The selected capacity (508) typically determines the load that will be applied during the evaluation. For instance, for battery capacities of less than 100 CCA, 120 CA, or 16 AH, a 1 ohm resistor load may be used. For battery capacities greater than 100CCA, 120CA, or 16AH a 0.1ohm resistor load may be used.

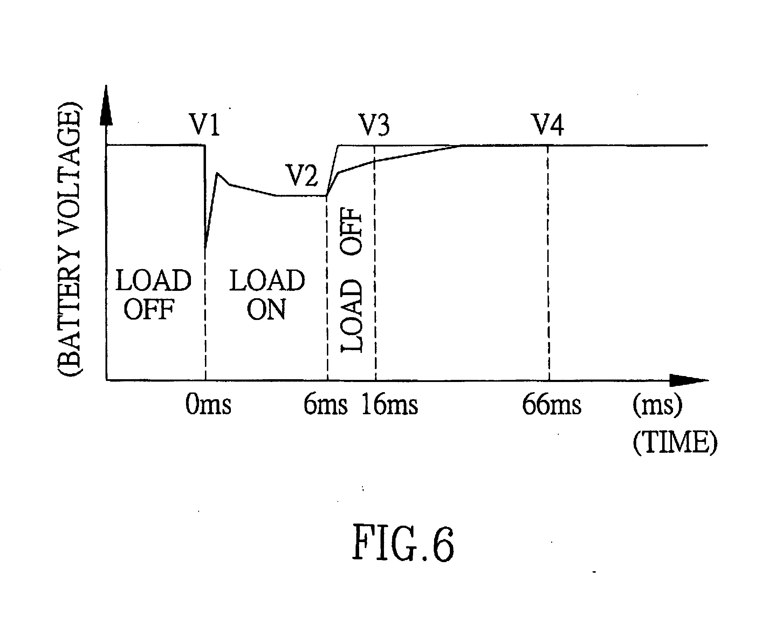

The condition of the battery may be calculated (513) by determining the internal dynamic resistance of the battery, using the applied single load (510). The load is typically applied (510) for a first time period. The first time period can be three milliseconds to ten seconds, four milliseconds to one second, five milliseconds to fifty milliseconds or six milliseconds to facilitate a rapid, accurate evaluation. Referring to Fig. 6, graph (600) shows that a first voltage V2 is measured at the end of the first time period. The load is removed (510) and, after a time period elapses, which is typically longer than the first time period, a second voltage V3 is measured at the end of a first recovery time period. The first recovery time period can be four milliseconds to one second, five milliseconds to five hundred milliseconds, six milliseconds to one hundred milliseconds, eight milliseconds to fifteen milliseconds, or ten milliseconds to facilitate a rapid, accurate evaluation. A third voltage V4 may be measured at the end of a second recovery time period after removing the load. The second recovery time period can be thirty milliseconds to ten seconds, forty milliseconds to two seconds, fifty milliseconds to one second, or sixty milliseconds to facilitate a rapid, accurate evaluation. The second recovery time period is longer than the first recovery time period, for example, by fifty milliseconds. During the evaluation, a load of between 10 amps and 100 amps is typically applied.

The internal resistance of the battery is calculated according to the equation: (V4-V2)/(V2/Rload)=Ri, where Rload is the resistor load and Ri is the internal resistance. The internal resistance of the battery is used to calculate the capacity of the battery. The measured voltages also are used to determine whether the battery passes or fails (516). Whether the battery passes the test can be determined by calculating the capacity of the battery and comparing with the input capacity. If the calculated capacity is greater than a predetermined percentage of the input capacity, for example, ninety percent, the battery passes the test. If V4-V3 is greater than a predetermined voltage, for example, 100 millivolts, then the battery passes the test. If V4-V3 is less than the predetermined voltage then the battery fails the test. If the battery fails the test, then it may be recharged and tested again. If the second evaluation fails, after a recharge, then the battery will not hold a charge and should be replaced. The overall time for evaluating the condition of a battery may be less than one second, less than 500 milliseconds, less than 250 milliseconds, or less than 100 milliseconds.

The described systems, methods, and techniques may be implemented in digital electronic circuitry, computer hardware, firmware software, or in combinations of these elements. Apparatus embodying these techniques may include appropriate input and output devices, a computer processor, and a computer program product tangibly embodied in a machine-readable storage device for execution by a programmable processor. A process embodying these techniques may be performed by a programmable processor executing a program of instructions to perform desired functions by operation on input data and generating appropriate output. The techniques may be implemented in one or more computer programs that are executable on a programmable system including at least one programmable processor coupled to receive data and instructions from, and to transmit data and instructions to, a data storage system, at least one input device, and at least one output device. Each computer program may be implemented in a high-level procedural or object-oriented programming language, or in assembly or machine language if desired; and in any case, the language may be a compiled or interpreted language. Suitable processors include, by way of example, both general and special purpose microprocessors. Generally, a processor will receive instructions and data from a read-only memory and/or a random access memory. Storage devices suitable for tangibly embodying computer program instructions and data include all forms of non-volatile memory, including by way of example semiconductor memory devices, such as Erasable Programmable Read-Only Memory (EPROM), Electrically Erasable Programmable Read-Only Memory (EEPROM), and flash memory disks; magnetic disks such as internal hard disks and removable disks; magneto-optical disks; and Compact Disc Read-Only Memory (CD-ROM). Any of the foregoing may be supplemented by, or incorporated in, specially-designed ASICs (application-specific integrated circuits).

A number of implementations have been described. Nevertheless, it will be understood that various modifications may be made. For example, advantageous results still could be achieved if steps of the disclosed techniques were performed in a different order and/or if components in the disclosed systems were combined in a different manner and/or replaced or supplemented by other components. Accordingly, other implementations are within the scope of the following claims.

## Claims

1. A method for evaluating the condition of a battery (202), the method comprising:
applying a load (510) to the battery (202) for a first time period of three milliseconds to ten seconds; measuring a first voltage (V2) at the end of the first time period;
removing the load (510);
measuring a second voltage (V3) at the end of a first recovery time period after removing the load (510); measuring a third voltage (V4) at the end of a second recovery time period after removing the load (510); and
analyzing the condition of the battery (202).

2. The method as claimed in claim 1, wherein the first time period is four milliseconds to one second.

3. The method as claimed in claim 1, wherein the first time period is six milliseconds.

4. The method as claimed in claim 1, wherein the first recovery time period is four milliseconds to one second.

5. The method as claimed in claim 1, wherein the first recovery time period is five milliseconds to five hundred milliseconds.

6. The method as claimed in claim 1, wherein the first recovery time period is ten milliseconds.

7. The method as claimed in claim 1, wherein the second recovery time period is longer than the first recovery time period.

8. The method as claimed in claim 1, wherein the second recovery time period is thirty milliseconds to ten seconds.

9. The method as claimed in claim 1, wherein the second recovery time period is sixty milliseconds.

10. The method as claimed in claim 1, wherein analyzing the condition of the battery (202) includes:
calculating a dynamic internal resistance for the battery (202) at the end of the second recovery time period; and
determining the condition of the battery (202) based on the dynamic internal resistance of the battery (202).

11. The method as claimed in claim 1 or 10, further comprising:
inputting a capacity (508) of the battery (202); and
selecting the load (510) to apply to the battery (202) based on the capacity (508).

12. The method as claimed in claim 1, wherein inputting the capacity (508) includes selecting between an input based on one of cold cranking amps (CCA), cranking amps (CA), and amp hours (AH).

13. The method as claimed in claim 1, wherein analyzing the condition of the battery (202) includes displaying a capacity (508) of the battery (202), a state of charge of the battery (202), or an indication of pass or fail (516).

14. A battery tester device (200) comprising:
a housing containing a load (218);
a switch (220), wherein the switch (220) applies the load (218) to the battery (202) for a first time period of three milliseconds to ten seconds and removes the load (218) from the battery (202);
an analyzing component that is structured and arranged to analyze the condition of the battery (202) at the end of a first recovery time period after removing the load (218) and a second recovery time period after removing the load (218); and
cables (108) exiting the housing for making electrical contact with terminals on the battery (202) and
contacting the switch (220).

15. The device as claimed in claim 14, wherein the first time period is four milliseconds to one second.

16. The device as claimed in claim 14, wherein the first time period is six milliseconds.

17. The device as claimed in claim 14, wherein the first recovery time period is four milliseconds to one second.

18. The device as claimed in claim 14, wherein the second recovery time period is thirty milliseconds to ten seconds.

19. The device as claimed in claim any of the preceding claims 14-18, wherein the analyzing component includes:
a calculating component that is structured and arranged to calculate the dynamic internal resistance for the battery (202); and
a determining component that is structured and arranged to determine the condition of the battery (202) based on the dynamic internal resistance of the battery (202).

20. The method as claimed in claim 11, wherein the first time period is five milliseconds to fifty milliseconds;
the first recovery time period is eight milliseconds to fifteen milliseconds; and
the second recovery time period is fifty milliseconds to one second.

## Patentansprüche

1. Verfahren zur Beurteilung des Zustands einer Batterie (202), wobei das Verfahren umfaßt:
Anlegen eines Verbrauchers (510) an die Batterie (202) für eine erste Zeitdauer von drei Millisekunden bis zehn Sekunden,
Messen einer ersten Spannung (V2) am Ende der ersten Zeitdauer,
Entfernen des Verbrauchers (510),
Messen einer zweiten Spannung (V3) am Ende einer ersten Erholzeitdauer nach Entfernen des Verbrauchers (510),
Messen einer dritten Spannung (V4) am Ende einer zweiten Erholzeitdauer nach Entfernen des Verbrauchers (510), und
Analysieren des Zustands der Batterie (202).

2. Verfahren nach Anspruch 1, **dadurch gekennzeichnet, daß** die erste Zeitdauer vier Millisekunden bis eine Sekunde beträgt.

3. Verfahren nach Anspruch 1, **dadurch gekennzeichnet, daß** die erste Zeitdauer sechs Millisekunden beträgt.

4. Verfahren nach Anspruch 1, **dadurch gekennzeichnet, daß** die erste Erholzeitdauer vier Millisekunden bis eine Sekunde beträgt.

5. Verfahren nach Anspruch 1, **dadurch gekennzeichnet, daß** die erste Erholzeitdauer fünf Millisekunden bis fünfhundert Millisekunden beträgt.

6. Verfahren nach Anspruch 1, **dadurch gekennzeichnet, daß** die erste Erholzeitdauer zehn Millisekunden beträgt.

7. Verfahren nach Anspruch 1, **dadurch gekennzeichnet, daß** die zweite Erholzeitdauer länger als die erste Erholzeitdauer ist.

8. Verfahren nach Anspruch 1, **dadurch gekennzeichnet, daß** die zweite Erholzeitdauer dreißig Millisekunden bis zehn Sekunden beträgt.

9. Verfahren nach Anspruch 1, **dadurch gekennzeichnet, daß** die zweite Erholzeitdauer sechzig Millisekunden beträgt.

10. Verfahren nach Anspruch 1, **dadurch gekennzeichnet, daß** das Analysieren des Zustands der Batterie (202) enthält:
Berechnen eines dynamischen Innenwiderstands für die Batterie (202) am Ende der zweiten Erholzeitdauer und Bestimmen des Zustands der Batterie (202) auf der Grundlage des dynamischen Innenwiderstands der Batterie (202).

11. Verfahren nach Anspruch 1 oder 10, **dadurch gekennzeichnet, daß** es ferner umfaßt:
Eingeben einer Kapazität (508) der Batterie (202) und Auswählen des Verbrauchers (510) zum Anlegen an die Batterie (202) auf der Grundlage der Kapazität (508).

12. Verfahren nach Anspruch 1, **dadurch gekennzeichnet, daß** Eingeben der Kapazität (508) Auswählen zwischen einer Eingabe, die auf einer von Kaltstartleistung (Cold Cranking Amps (CCA)), Startleistung (Cranking Amps (CA)) und Amperestunden (Amp Hours (AH)) basiert, enthält.

13. Verfahren nach Anspruch 1, **dadurch gekennzeichnet, daß** Analysieren des Zustands der Batterie (202) Anzeigen einer Kapazität (508) der Batterie (202), eines Ladezustands der Batterie (202) oder einer Anzeige von Bestanden oder Durchgefallen (516) enthält.

14. Batterietestgerät (200), umfassend:
ein Gehäuse, das einen Verbraucher (218) enthält,
einen Schalter (220), wobei der Schalter (220) den Verbraucher (218) an die Batterie (202) für eine erste Zeitdauer von drei Millisekunden bis zehn Sekunden anlegt und den Verbraucher (218) von der Batterie (202) entfernt,
eine Analysekomponente, die so strukturiert und gestaltet ist, daß sie den Zustand der Batterie (202) am Ende einer ersten Erholzeitdauer nach Entfernen des Verbrauchers (218) und einer zweiten Erholzeitdauer nach Entfernen des Verbrauchers (218) analysiert, und
Kabel (108), die aus dem Gehäuse zur Herstellung von elektrischem Kontakt mit Anschlüssen an der Batterie (202) und Kontaktieren des Schalters (220) austreten.

15. Gerät nach Anspruch 14, **dadurch gekennzeichnet, daß** die erste Zeitdauer vier Millisekunden bis eine Sekunde beträgt.

16. Gerät nach Anspruch 14, **dadurch gekennzeichnet, daß** die erste Zeitdauer sechs Millisekunden beträgt.

17. Gerät nach Anspruch 14, **dadurch gekennzeichnet, daß** die erste Erholzeitdauer vier Millisekunden bis eine Sekunde beträgt.

18. Gerät nach Anspruch 14, **dadurch gekennzeichnet, daß** die zweite Erholzeitdauer dreißig Millisekunden bis zehn Sekunden beträgt.

19. Gerät nach einem der vorangehenden Ansprüche 14 bis 18, **dadurch gekennzeichnet, daß** die Analysekomponente enthält:
eine Rechenkomponente, die strukturiert und gestaltet ist, um den dynamischen Innenwiderstand für die Batterie (202) zu berechnen, und
eine Ermittlungskomponente, die strukturiert und gestaltet ist, um den Zustand der Batterie (202) auf der Grundlage des dynamischen Innenwiderstands der Batterie (202) zu ermitteln.

20. Verfahren nach Anspruch 11, **dadurch gekennzeichnet, daß** die erste Zeitdauer fünf Millisekunden bis fünfzig Millisekunden beträgt, die erste Erholzeitdauer acht Millisekunden bis fünfzehn Millisekunden beträgt und
die zweite Erholzeitdauer fünfzig Millisekunden bis eine Sekunde beträgt.

## Revendications

1. Procédé d'évaluation de l'état d'une batterie (202), le procédé comprenant :
l'application d'une charge (510) à la batterie (202) pendant une première période comprise entre 3 ms et 10 s,
la mesure d'une première tension (V2) à la fin de la première période,
la suppression de la charge (510),
la mesure d'une seconde tension (V3) à la fin d'une première période de rétablissement après enlèvement de la charge (510),
la mesure d'une troisième tension (V4) à la fin d'une seconde période de rétablissement après enlèvement de la charge (510), et
l'analyse de l'état de la batterie (202).

2. Procédé selon la revendication 1, dans lequel la première période est comprise entre 4 ms et 1 s.

3. Procédé selon la revendication 1, dans lequel la première période est de 6 ms.

4. Procédé selon la revendication 1, dans lequel la première période de rétablissement est comprise entre 4 ms et 1 s.

5. Procédé selon la revendication 1, dans lequel la première période de rétablissement est comprise entre 5 ms et 500 ms.

6. Procédé selon la revendication 1, dans lequel la première période de rétablissement est égale à 10 ms.

7. Procédé selon la revendication 1, dans lequel la seconde période de rétablissement est plus longue que la première période de rétablissement.

8. Procédé selon la revendication 1, dans lequel la seconde période de rétablissement est comprise entre 30 ms et 10 s.

9. Procédé selon la revendication 1, dans lequel la seconde période de rétablissement est égale à 60 ms.

10. Procédé selon la revendication 1, dans lequel l'analyse de l'état de la batterie (202) comprend :
le calcul d'une résistance interne dynamique de la batterie (202) à la fin de la seconde période de rétablissement, et
la détermination de l'état de la batterie (202) d'après la résistance interne dynamique de la batterie (202).

11. Procédé selon la revendication 1 ou 10, comprenant en outre :
la saisie d'une capacité (508) de la batterie (202), et
la sélection de la charge (510) destinée à être appliquée à la batterie (202) en fonction de la capacité (508).

12. Procédé selon la revendication 1, dans lequel la saisie de la capacité (508) comprend la sélection entre une entrée exprimée en ampères de démarrage à froid (CCA), en ampères de démarrage (CA) et en ampères-heures (AH).

13. Procédé selon la revendication 1, dans lequel l'analyse de l'état de la batterie (202) comprend l'affichage d'une capacité (508) de la batterie (202), d'un état de charge de la batterie (202) ou d'une indication du succès ou non de l'essai (516).

14. Appareil (200) de test de batterie, comprenant :
un boîtier contenant une charge (218),
un commutateur (220), le commutateur (220) appliquant la charge (218) à la batterie (202) pendant une première période comprise entre 3 ms et 10 s et supprimant la charge (218) de la batterie (202),
un élément d'analyse ayant une structure et une disposition telles qu'il analyse l'état de la batterie (202) à la fin d'une première période de rétablissement après la suppression de la charge (218) et d'une seconde période de rétablissement après la suppression de la charge (218), et
des câbles (108) sortant du boîtier pour former un contact électrique avec des bornes de la batterie (202) et en contact avec le commutateur (220).

15. Appareil selon la revendication 14, dans lequel la première période est comprise entre 4 ms et 1 s.

16. Appareil selon la revendication 14, dans lequel la première période est égale à 6 ms.

17. Appareil selon la revendication 14, dans lequel la première période de rétablissement est comprise entre 4 ms et 1 s.

18. Appareil selon la revendication 14, dans lequel la seconde période de rétablissement est comprise entre 30 ms et 10 s.

19. Appareil selon l'une quelconque des revendications précédentes 14 à 18, dans lequel l'élément d'analyse comprend :
un élément de calcul ayant une structure et une disposition telles qu'il calcule la résistance interne dynamique de la batterie (202), et
un élément de détermination qui a une structure et une disposition telles qu'il détermine l'état de la batterie (202) en fonction de la résistance interne dynamique de la batterie (202).

20. Procédé selon la revendication 11, dans lequel la première période est comprise entre 5 ms et 50 ms,
la première période de rétablissement est comprise entre 8 ms et 15 ms, et
la seconde période de rétablissement est comprise entre 50 ms et 1 s.
